# EUROPEAN PATENT SPECIFICATION

(11) **EP 0 735 572 B1**
(45) Date of publication and mention of the grant of the patent: **19.06.2002**
(21) Application number: 95400683.9
(22) Date of filing: 28.03.1995
(51) Int. Cl.: H01L 21/00, B01L 1/00

(54) **Container for semiconductor wafers**
Behälter für Halbleiterplättchen
Conteneur pour des plaquettes semiconductrices

(43) Date of publication of application: 02.10.1996
(73) Proprietor: FLUOROWARE, INC., Chaska, MN 55318 (US)
(72) Inventor: Ring, David J., Bloomington, Minnesota 55431 (US); Williams, Randall S., Chaska, Minnesota 55318 (US); Shindley, Richard P., Chaska, Minnesota 55318 (US)
(74) Representative: Rinuy, Santarelli

(56) References cited:
- WO-A-87/04043
- DE-A- 4 342 976
- IBM TECHNICAL DISCLOSURE BULLETIN, vol. 16, no. 4, September 1973 NEW YORK US, pages 1289-1290, BUCHMANN 'WAFER CARRIER/BUFFER'

## Description

This invention relates to closed containers for storing and delivering semiconductor wafers or slices to and from processing equipment in clean condition and to protect such wafers against contaminating influences including airborne particles.

### BACKGROUND OF THE INVENTION

In the processing of semiconductor wafers, there is a clear relation between chip yield and particle contamination, as the yield decreases when particle contamination increases. Concern for particle contamination is increased because finer geometries of the circuit lines on a chip may allow particles of smaller and smaller sizes to cause contamination. Furthermore, the density of particles in a cleanroom may increase dramatically as the size of the contaminating particles decreases.

More and more the nature and functionality in confining containers for semiconductor wafers becomes extremely important in order to efficiently supply semiconductor wafers to processing equipment easily, while minimizing the possibility of allowing introduction of contaminating particles

Wafer containers are known in which the wafers sit on ribs supporting the wafers and springs engage the wafers at their front edges to force the wafers against a back surface and to hold them down on the shelves. See IBM Technical Disclosure Bulletin, Vol. 16, n° 4, 1973, N.Y., pg. 1289-1290. Such containers still have the capability of particle generation by the contact of the wafers with the shelves.

### SUMMARY OF THE INVENTION

An object of the invention according to claim 1 is to provide a new and improved closed container for semiconductor wafers, to establish a confined atmosphere around such wafers, and minimize access by contaminating particles to such wafers.

A feature of the invention is a closed wafer container which retains the wafers against movement and thereby minimizes generation of particles during wafer storage, and whereby the container is readily and easily manipulable as to permit easily opening and closing the container and moving portions of the container to an out-of-the-way position in order to obtain access to the wafers.

### BRIEF DESCRIPTION OF THE DRAWINGS

Figure 1 is a diagrammatic view illustrating prior art supplying of semiconductor wafers into processing equipment through an enclosing canopy.

Figure 2 is a section view of a semiconductor wafer storage container, the section being taken approximately at 2-2 of Figure 3.

Figure 3 is a section view of the wafer storage container illustrated in Figure 2 and taken approximately at 3-3 of Figure 2.

Figure 4 is an enlarged detail section view taken approximately at 4-4 of Figure 2.

Figure 5 is a detail section view taken approximately at 5-5 of Figure 4.

Figure 6 is a detail elevation view of one of the wafer engaging seat portions of Figure 4.

### DETAILED SPECIFICATION

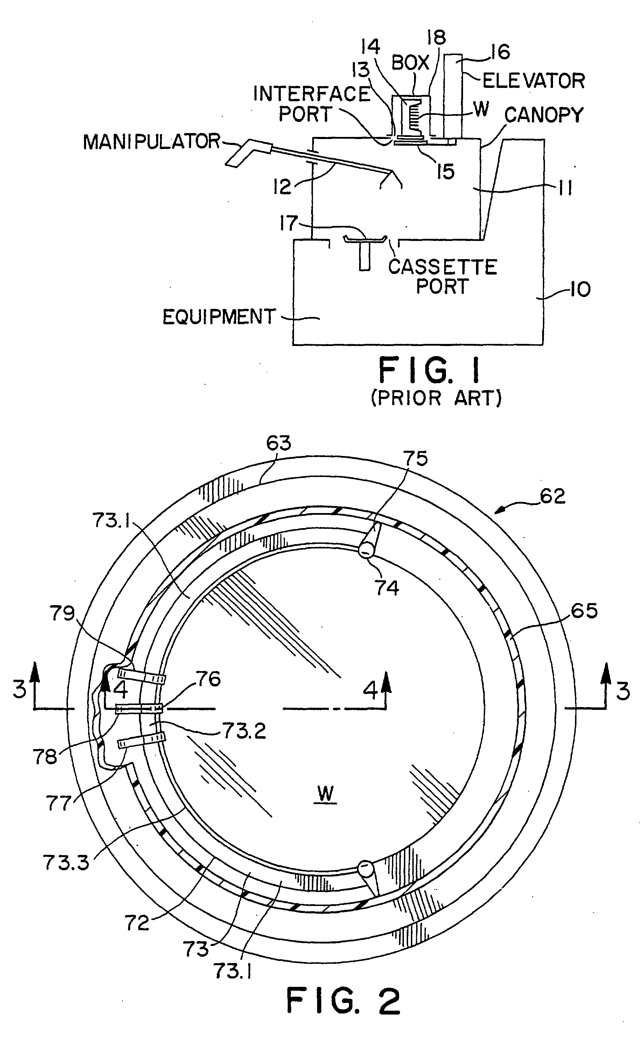

A piece of equipment is illustrated in Figure 1 at numeral 10 for processing semiconductor wafers in one of the many steps required in the production of circuit chips. Typical of such process steps may be etching of oxide of the wafers, or application of photoresist or rinsing and drying, etc. It has been rather common in the past to provide a canopy 11 on the equipment or machine 10 and some type of manipulator 12 for handling wafer cassettes or containers being supplied to the equipment. The canopy 11 typically has an interface port or opening 13 through which semiconductor wafers W, confined in a cassette 14, are supplied through the canopy and into the interior of the canopy for feeding into the processing equipment. The interface port is typically closed by a door or closure 15 which serves to support the cassette or carrier 14; and the closure 15 is connected to an elevator 16 for lowering the cassette or carrier 14 into the interior of the canopy. The manipulator arm 12 may be operated to lift the carrier or cassette 14 off the door 15 and place the wafers and their carrier onto another platform 17 for delivery into the processing equipment.

A box 18, which has previously been known as a SMIF box, fits over the interface port and delivers the cassette or carrier 14 of the wafers W to the canopy for delivery into the equipment 10. The box 18 has a receptacle portion which may rest upon the canopy adjacent the port 13; and a cover which may rest upon the door 15. The box 18 is useful for the purpose of minimizing the selection of airborne particles and similar contaminants onto the wafers as the wafers are being supplied into or removed from the equipment 10.

The acronym SMIF refers to a STANDARD MECHANICAL INTERFACE, referring to the relationship between the box and the canopy.

In Figures 2-6, a semiconductor wafer storage container is indicated in general by numeral 62 and comprises a two-part molded plastic box 63 with a flat side portion 64 which may form the bottom of the box. The box 63 includes a receptacle portion 65 and a cover portion 66. The cover portion comprises a closure panel 67 and a retainer panel 68 retained by a quarter turn thread 69 in the peripheral portion 70 of the receptacle 65. It will be seen that the peripheral portion of the closure panel 67 lies against an annular shoulder 70.1 of the receptacle periphery; and the retainer panel 68 is also seated against the shoulder portion 70.1 and supports the annular periphery or flange 71 of the closure panel.

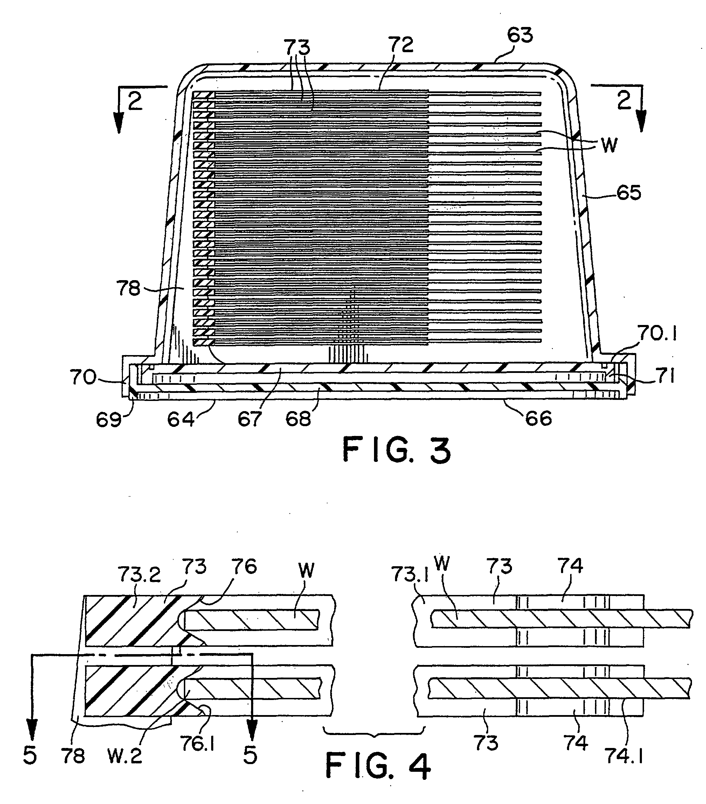

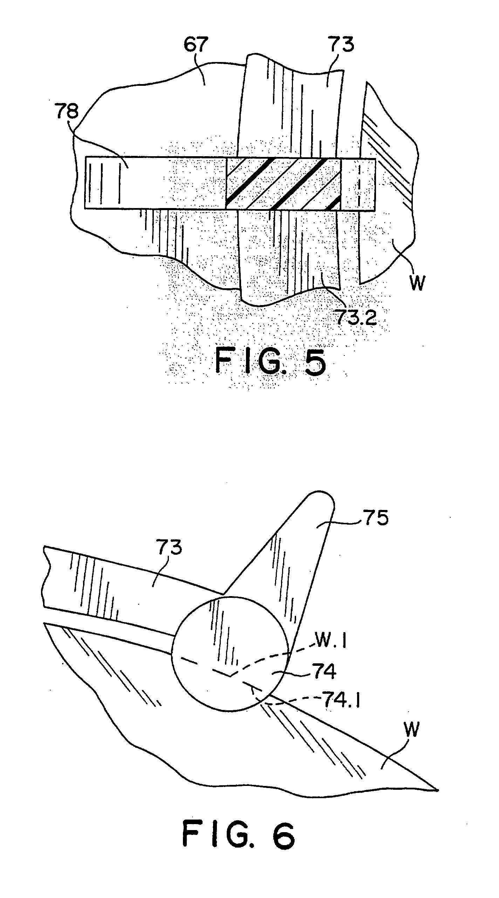

The container 62 also comprises stationary engaging means 72 for engaging the peripheries of the semiconductor wafers W and retaining the wafers against edgeways movements in the planes of the wafers. The engaging means 72 comprise a plurality of C-shaped wafer gripping portions or clamping portions 73 which extend around the peripheries of the wafers. Referring to Figures 2, 4, 5 and 6, gripping portions 73 have resilient yieldable arm portions 73.1 and an intermediate portion 73.2. The arm portions 73.1 define notched or grooved wafer seating and retaining portions 74 at their opposite outer ends. The C-shaped wafer gripping portions 73 and particularly the arm portions 73.1, closely follow the peripheries and edge portions W.1 and W.2 of the wafers and are arcuately and partially circularly shaped, and are also resiliently yieldable to spring slightly outwardly to release the wafers when outward pressure is applied onto the manipulating handles 75. The C-shaped wafer gripping portions 73 define a partially circular interior edge 73.3, and it will be recognized that the open interior portion is shaped greater than a semicircle. Each of the seating portions 74 urge the circular wafer W against the other seating portion 74 and against the seating portion 76. As seen in Figure 2, the seating portions 74 on the arm portions 73.1 and the seating portion 76 on the intermediate portion 73.2 define the actual circular boundaries of the partially circular open interior portion 73.3. The wafer gripping portions 73 also define wafer seating portions 76 in the form of notches as seen in Figure 4. The notches 74.1, 76.1 in seating portions 74 and in seating portions 76, are oriented intermediate the thicknesses of the arm portions 73.1 and the intermediate portions 73.2, as illustrated in Figures 4 and 6 to seat the edge portions W.1 and W.2 of the wafer.

The multiplicity of C-shaped wafer gripping portions 73 are affixed to and supported on three posts 77, 78 and 79 which protrude upwardly and are affixed to the stationary cover panel 67.

When the wafers are to be removed from the box 63, the retainer panel 68 will be revolved in its own plane through a quarter turn to be released from the adjacent periphery 70 of the receptacle, and then the retainer panel 68 and the cover panel 67 may simply be lowered out of the receptacle 65, carrying the wafers therewith.

The present invention may be embodied in other specific forms without departing from the spirit or essential attributes thereof, and it is therefore desired that the present embodiment be considered in all respects as illustrative and not restrictive, reference being made to the appended claims rather than to the foregoing description to indicate the scope of the invention.

## Claims

1. A container (62) for containing and retaining semiconductor wafers (W), the wafers (W) having a peripheral edge (W.1), the container (62) of the type having a receptacle portion (65), a removable cover portion (66), and a plurality of axially aligned wafer gripping portions (73) that are engageable with the peripheral edge (W.1) of the semiconductor wafers, the gripping portions (73) each comprised of an intermediate portion (73.2) attached to and stationary with the container and a pair of resilient arm portions (73.1) each pair of resilient arm portions defines grooved wafer seating and retaining portions (74) at opposite ends of the arm portions (73.1), **characterized in that** each wafer gripping portion (73) is C-shaped, the C-shaped wafer gripping portions (73) and particularly their arm portions (73.1) are adapted to closely follow the peripheral edges (W.1) of the wafers (W) and are partially circularly shaped, and each arm portion (73.1) has a manipulating handle (75), the arm portions (73.1) are resiliently yieldable to spring slightly outwardly to release the wafers (W) upon application of outward pressure to the manipulating handles (75).

2. The container (62) of claim 1 wherein each pair of resilient arm portions (73.1) define an arc greater than a semicircle whereby when a wafer (W) is retained within a C-shaped wafer gripping portion (73), the resilient arm portions (73.1) extend around the periphery of the semiconductor wafer (W) in an arc greater than a semicircle whereby the wafer (W) is retained within said C-shaped wafer gripping portion (73).

3. The container (62) of claim 1 wherein each of the intermediate portions (73.2) have a seating portion (76) with a notch (76.1) for seating the wafer.

4. The container (62) of claim 1 wherein the arm portions (73.1) are integral with the intermediate portions (73.2).

## Patentansprüche

1. Behälter (62) zum Einschließen und Aufbewahren von Halbleiterplättchen (W), wobei die Plättchen (W) eine umfangsseitige Kante (W.1) aufweisen, wobei der Behälter (62) von der Art ist, die einen Gefäßabschnitt (65), einen entfernbaren Deckelabschnitt (66) und eine Vielzahl axial ausgerichteter Plättchengreifabschnitte (73), die mit der Umfangskante (W.1) der Halbleiterplättchen in Eingriff bringbar sind, aufweist, wobei jeder der Greifabschnitte (73) einen Mittelabschnitt (73.2), der am Behälter angebracht und an diesem ortsfest ist, und ein Paar elastische Armabschnitte (73.1) aufweist, wobei jedes Paar elastische Armabschnitte gerillte Aufnahme- und Aufbewahrungsabschnitte (74) an gegenüberliegenden Enden der Armabschnitte (73.1) begrenzt, **dadurch gekennzeichnet, daß** jeder Plättchengreifabschnitt (73) C-förmig ist, daß die C-förmigen Plättchengreifabschnitte (73) und insbesondere ihre Armabschnitte (73.1) dafür ausgelegt sind, den umfangseitigen Kanten (W.1) der Plättchen (W) nahe zu folgen, und teilweise kreisförmig ausgebildet sind, und daß jeder Armabschnitt (73.1) einen Betätigungshandgriff (75) aufweist, wobei die Armabschnitte (73.1) elastisch biegbar sind, um geringfügig nach außen zu federn, um die Plättchen (W) auf das Anlegen eines äußeren Druckes auf die Betätigungshandgriffe (75) hin freizusetzen.

2. Behälter (62) nach Anspruch 1, **dadurch gekennzeichnet, daß** jedes Paar elastische Armabschnitte (73.1) einen Bogen begrenzt, der größer als ein Halbkreis ist, wodurch, wenn ein Plättchen (W) innerhalb eines C-förmigen Plättchengreifabschnitts (73) aufbewahrt wird, die elastischen Armabschnitte (73.1) sich um den Umfang des Halbleiterplättchens (W) in einem Bogen erstrecken, der größer als ein Halbkreis ist, wodurch das Plättchen (w) innerhalb des C-förmigen Plättchengreifabschnitts (73) aufbewahrt wird.

3. Behälter (62) nach Anspruch 1, **dadurch gekennzeichnet, daß** jeder der Mittelabschnitte (73.2) einen Aufnahmeabschnitt (76) mit einer Kerbe (76.1) zum Aufnehmen des Plättchens aufweist.

4. Behälter (62) nach Anspruch 1, **dadurch gekennzeichnet, daß** die Armabschnitte (73.1) mit den Mittelabschnitten (73.2) integral ausgebildet sind.

## Revendications

1. Récipient (62) destiné à contenir et retenir des tranches semiconductrices (W), les tranches (W) ayant un bord périphérique (W.1), le récipient (62) du type ayant une partie formant réceptacle (65), une partie formant couvercle amovible (66), et une pluralité de parties (73) de prise de tranches, alignées axialement, qui peuvent engager le bord périphérique (W.1) des tranches semiconductrices, les parties de prise (73) étant constituées chacune d'une partie intermédiaire (73.2) reliée fixement au récipient et d'une paire de parties de bras élastiques (73.1), chaque paire de parties de bras élastiques définissant des parties rainurées (74) de logement et de retenue de tranche à des extrémités opposées des parties de bras (73.1), **caractérisé en ce que** chaque partie (73) de prise de tranche est en forme de C, les parties (73) de prise de tranche en forme de C et en particulier leurs parties de bras (73.1) sont conçues pour suivre étroitement les bords périphériques (W.1) des tranches (W) et sont conformées de façon partiellement circulaire, et chaque partie de bras (73.1) comporte une manette (75) de manipulation, les parties de bras (73.1) peuvent fléchir élastiquement pour faire saillie légèrement vers l'extérieur afin de libérer les tranches (W) lors de l'application d'une pression vers l'extérieur sur les manettes de manipulation (75).

2. Récipient (62) selon la revendication 1, dans lequel chaque paire de parties de bras élastiques (73.1) définit un arc supérieur à un demi-cercle grâce à quoi, lorsqu'une tranche (W) est retenue dans une partie de prise de tranche (73) en forme de C, les parties de bras élastiques (73.1) s'étendent autour de la périphérie de la tranche semiconductrice (W) en un arc supérieur à un demi-cercle, grâce à quoi la tranche (W) est retenue dans ladite partie de prise de tranche (73) en forme de C.

3. Récipient (62) selon la revendication 1, dans lequel chacune des parties intermédiaires (73.2) comporte une partie de logement (76) ayant une encoche (76.1) destinée à loger la tranche.

4. Récipient (62) selon la revendication 1, dans lequel les parties de bras (73.1) sont réalisées d'une seule pièce avec les parties intermédiaires (73.2).
